# EUROPEAN PATENT APPLICATION

(11) **EP 4 674 805 A1**
(43) Date of publication of application: **07.01.2026**
(21) Application number: 24185590.7
(22) Date of filing: 01.07.2024
(51) Int. Cl.: B81B 3/00

(54) **MEMS DEVICE WITH RESONATING STRUCTURE**

(71) Applicant: Murata Manufacturing Co., Ltd., Nagaokakyo-shi, Kyoto 617-8555 (JP)
(72) Inventor: KAAJAKARI, Ville, 00350 Helsinki (FI)
(74) Representative: Boco IP Oy Ab

(57) **Abstract**

A MEMS device which comprises a structure which is configured to undergo bending oscillation in a plane. The structure comprises a first end, a second end, a first side region, a second side region and a central region which extends from the first end to the second end between the first side region and the second side region. The central region comprises one or more openings which extend through the structure.

## Description

### FIELD OF THE DISCLOSURE

This disclosure relates to microelectromechanical (MEMS) devices, and more particularly devices where a structure experiences resonant oscillation. The present disclosure further concerns thermoelastic damping in such structures.

### BACKGROUND OF THE DISCLOSURE

Many microelectromechanical devices comprise one or more mobile parts. Some mobile parts are substantially rigid and experience very little structural deformation when the device is in use. Other mobile parts are so flexible that they can undergo deformation. Flexible parts may for example oscillate in resonance by bending back and forth. Such bending oscillators may form stand-alone oscillators which are not connected to other mobile parts.

Alternatively, rigid mobile parts (such as proof masses) may be suspended from an adjacent fixed structure by one or more flexible suspenders which are used as bending oscillators. The proof mass and its suspenders may then undergo resonance oscillation together.

Resonating oscillation can be driven by force transducers and/or by external forces which act on the mobile parts. Force transducers may in some applications be used as sense transducers which measure the effect of an external force on the mobile parts.

Thermoelastic damping can occur in any oscillating structure which undergoes structural deformation, such as bending. Compression of the material on a first side (the "inside" of the bending motion) raises the local temperature in the material on that side, while stretching of the material on a second side (the outside) reduces the local temperature on that side. In the opposite phase of the oscillation cycle the first side becomes the cooler "outside" of the bending motion and the second side becomes the warmer inside.

At some oscillation frequencies this alternating temperature gradient, and the consequent back-and-forth heat flow inside the oscillating structure, dissipates a part of the mechanical oscillation energy. The greater the dissipation, the smaller the quality factor of the oscillator. A common problem in mobile parts which are configured to undergo bending is that this thermoelastic damping effect is prominent at the desired operating frequency of the device.

### BRIEF DESCRIPTION OF THE DISCLOSURE

An object of the present disclosure is to provide arrangements which can reduce thermoelastic damping in MEMS devices.

The object of the disclosure is achieved by an arrangement which is characterized by what is stated in the independent claim. The preferred embodiments of the disclosure are disclosed in the dependent claims.

The disclosure is based on the idea of reducing heat flow in an oscillating structure by increasing its internal thermal resistance.

### BRIEF DESCRIPTION OF THE DRAWINGS

In the following, the disclosure will be described in greater detail by means of preferred embodiments with reference to the accompanying drawings, in which:
Figures 1a - 1c illustrate a structure which is configured to undergo bending oscillation in a plane.
Figures 2a - 2d illustrate openings in the structure.
Figures 3a - 3b illustrate openings and bridge elements between openings.
Figure 4 illustrates a net shaped bridge element, where bridges are not aligned.
Figures 5a - 5d illustrate piezoelectric transducers on the structure.
Figures 6a - 6b illustrate an alternative piezoelectric transducer configuration.

### DETAILED DESCRIPTION OF THE DISCLOSURE

This disclosure describes a MEMS device which comprises a structure which is configured to undergo bending oscillation in a plane. The structure comprises a first end and a second end. The structure also comprises a first side region which extends from the first end to the second end, and a second side region which extends from the first end to the second end. The structure also comprises a central region which extends from the first end to the second end between the first side region and the second side region.

The first side region lies on a first side of the central region, and the second side region lies on a second side of the central region. The first side of the central region is opposite to the second side of the central region. The central region comprises one or more openings which extend through the structure.

Any structure described in this disclosure may be a part of a MEMS device. The MEMS device may be a timing device or a frequency reference device. Alternatively, the MEMS device may be gyroscope or a mirror device.

Any structure described in this disclosure may be a stand-alone oscillator which is not connected to other mobile parts. Alternatively, the MEMS device may also comprise other mobile parts, for example proof masses, and the structure described in this disclosure may be attached to those parts. These other mobile parts may be suspended from adjacent fixed anchor points, which are also parts of the MEMS device, by one or more flexible suspenders which support the weight of mobile parts and allow them to move in relation to the fixed anchor points. These flexible suspenders may comprise any structure described in this disclosure. Another possibility is that the MEMS device may comprise multiple mobile parts and flexible couplers which extend from one mobile part to another mobile part. The flexible couplers may be configured to guide the movement of the mobile parts in relation to each other. These flexible couplers may comprise any structure described in this disclosure. All mobile parts may undergo resonance oscillation together.

The structures described in this disclosure may be elongated beams, and they are illustrated as elongated beams in the figures. However, other shapes are also possible. Thermoelastic damping can occur in any structure which undergoes deformation, regardless of its exact shape.

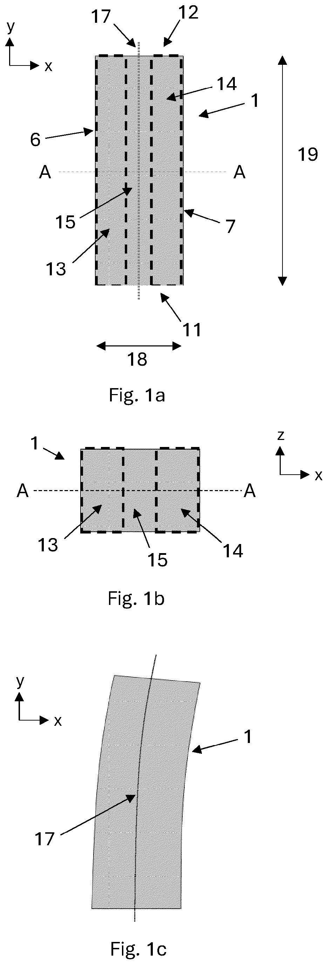

Figure 1a illustrates a structure 1 which is configured to undergo bending oscillation in a plane. This plane is illustrated as an xy-plane in the figures of this disclosure. The structure 1 may be formed in a device layer, which may for example be a device wafer or a layer deposited on a surface. The xy-plane may lie in the device layer.

The structure 1 comprises a first end 11 and a second end 12. The first end 11 may be attached to a fixed anchor point (not illustrated), so that the position of the first end 11 with respect to the surrounding fixed parts of the MEMS device does not change when the structure 1 undergoes bending oscillation. Alternatively, both the first end 11 and the second end 12 may be attached to other mobile parts, so that the positions of both the first end 11 and the second end 12 with respect to the surrounding fixed parts of the MEMS device change when the structure 1 undergoes bending oscillation.

In any embodiment described in this disclosure, the structure may be made of silicon. However, thermoelastic damping occurs in most materials, and the principles described in this disclosure are applicable to oscillating structures made of any material.

The structure in figure 1a comprises a first side region 13, a second side region 14 and a central region 15. The central region lies between the first and second side regions in the x-direction. The side regions 13 and 14 and the central region 15 extend from the first end 11 to the second end 12 in the y-direction, which is perpendicular to the x-direction.

The word "side" refers in this disclosure to the edges of the structure 1 which are opposite to each other in the x-direction, i.e. on the left and right sides in figure 1a. The word "end" refers to the edges of the structure 1 which are opposite to each other in the y-direction, i.e. on the top and bottom in figure 1a.

The structure 1 may have an elongated shape. The structure 1 may have the shape of a rectangular beam in its rest position when no deformation is present. Other shapes are also possible. The structure 1 will of course no longer have its rest position shape when it undergoes bending deformation, as figure 1c illustrates.

The length 19 of the structure 1 may be defined as the distance from the first end 11 to the second end 12 in the y-direction. The width 18 of the structure may be defined as the distance from the first side 6 to the second side 7 in the x-direction. If the width of the structure varies as a function of the y-coordinate, then a mean width may be calculated. In any embodiment presented in this disclosure, the length / width (or length / mean width) aspect ratio of the structure 1 may for example be in the range 3 - 100, or in the range 5 -20.

Figure 1b illustrates an xz-cross section of the structure 1 along the line A-A in figure 1a. The first and second side regions 13 and 14 and the central region 15 may extend through the structure 1 in the z-direction which is perpendicular to the xy-plane. In any embodiment presented in this disclosure, the widths of the first and second side regions 13 and 14 and the central region 15 in the x-direction may for example be substantially equal, as figures 1a and 1b illustrate. Alternatively, the central region may either be wider or narrower than either of the first and second side regions 13 and 14 in the x-direction, and the first and second side regions may have equal width.

A straight longitudinal line 17 may be drawn through the structure 1 along its entire length from the first end 11 to the second end 12 when the structure is in an undeformed state, as figure 1a illustrates. Bending may be defined as a change in curvature in this longitudinal line. Figure 1c illustrates bending to the right. The structure 1 may be configured to undergo bidirectional bending, so that the structure 1 alternates between a bent-right position (illustrated in figure 1c) and a bent-left position (not illustrated). The bending oscillation described in this disclosure may be resonance oscillation.

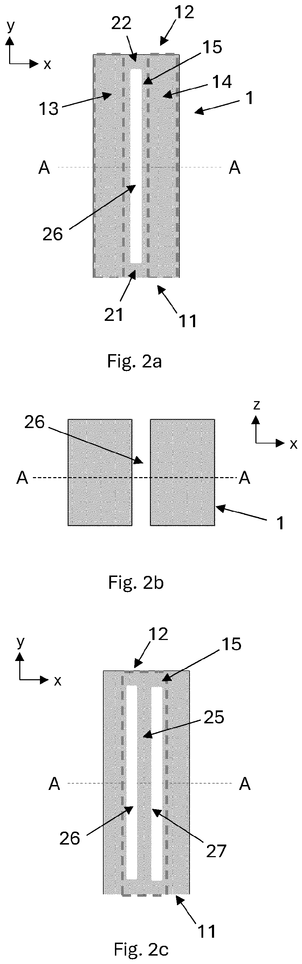

Figures 2a and 2b illustrate an embodiment where the one or more openings comprise a single opening 26 in the structure 1. It can be seen in figure 2b, which shows an xz-cross-section along the line A-A in figure 2a, that the opening 26 extends through the structure 1 in the z-direction. All openings described in this disclosure extend all the way through the structure 1 in the z-direction in the same manner as opening 26 in figure 2b. In other words, the one or more openings extend through the structure in a direction which is perpendicular to the plane. The openings may alternatively be called grooves.

The opening 26 occupies a large portion of the central region 15 in this case. The structure 1 comprises a first end bridge 21 and a second end bridge 22 which join the first and second side regions 13 and 14 to each other near the first (11) and second (12) end of the structure 1, respectively. An anchor point could alternatively serve the same function as the first end bridge 21 in embodiments where the first end is anchored.

A few general design considerations, which apply to all embodiments presented in this disclosure, may be noted with reference to figure 2a. Firstly, assuming that the gas or vacuum which occupies the opening 26 has a lower heat conductivity than the material of structure 1, the presence of the opening 26 in the central region 15 increases the thermal resistance between the first and second side regions 13 and 14. A small amount of heat transfer may still occur through first and second end bridges 21 and 22, but heat transfer between the first and second side regions 13 and 14 during bending oscillation will be markedly reduced compared to the structure illustrated in figure 1a. The thermoelastic damping effect will therefore be weaker in the structure 1 shown in figure 2a than in figure 1a.

Secondly, the structure 1 should undergo bending oscillation as a single body. That is, the first and second side regions 13 and 14 and the central region 15 should move together and bend in the same direction in bending oscillation. If the first and second end bridges 21 and 22 would be very narrow in the y-direction (or, more generally, if their length in the x-direction would be much greater than their width in the y-direction), they would be flexible. Very flexible end bridges may allow the first and second side regions 13 and 14 to resonate in different resonance modes, and the structure 1 would no longer oscillate as a single body, but as two bodies interconnected with flexure. Consequently, the mechanical integrity of the structure 1 during bending oscillation should be ensured by making bridge elements sufficiently rigid, and the size of the one or more openings in the structure 1 can therefore not be increased without limit, but many different options are possible, as explained below.

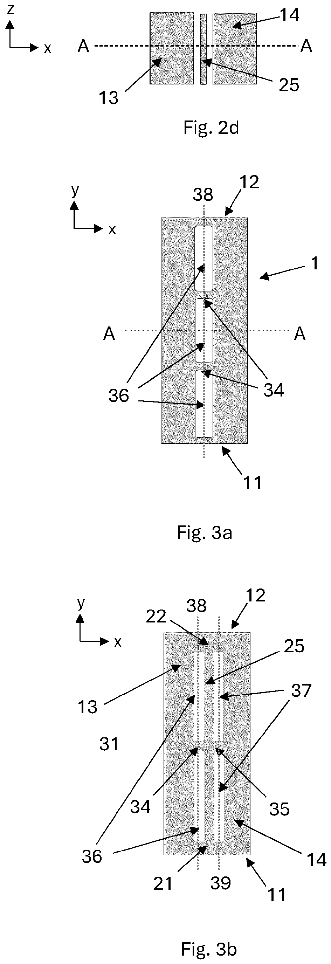

The one or more openings may comprise two or more openings, and the central region may comprise one or more bridge elements which separate the two or more openings from each other. Figure 2c illustrates a structure 1 where the two or more openings in the central region 15 comprise a first opening 26 and a second opening 27. End bridges are arranged in the central region 15 in the same way as in figure 2a. The central region 15 of structure 1 also comprises a central bridge element 25 which extends from the first end 11 of the structure 1 to the second end 12 and lies between the first opening 26 and the second opening 27. The central bridge element 25 thereby separates the first opening 26 from the second opening 27. The first opening 26 and the second opening 27 are substantially parallel to each other and have different x-coordinates. Figure 2d illustrates the xz-cross-section of the structure 1 in figure 2c along the line A-A.

Any opening described in this disclosure may have an elongated shape, as the figures of this disclosure illustrate. In other words, the length of each opening in the y-direction may be greater than its width in the x-direction. The length / width aspect ratio of each of the one or more openings may for example be greater than 3, greater than 5 or greater than 10. An elongated shape is typically useful since it can increase thermal resistance between the left and right sides of the structure 1 without reducing the bending stiffness of the structure 1 very much. However, the one or more openings may have any shape and the optimal shape may depend on the shape of the structure 1 itself.

Figure 3a illustrates a structure 1 which comprises three first openings 36 and two first bridge elements 34. They all lie on a first central line 38 which extends in the length direction of the structure 1 (in the direction of the y-axis in figure 3a). The first central line may in this case lie in the middle of the structure 1 in the x-direction. It can easily be seen that if the number of first bridge elements 34 is and integer N, then the number of first openings is N+1. The optimal value for N depends on the considerations that were discussed above. On the one hand, it would make sense to minimize N since each first bridge element 34 acts as a heat conductance path between the first side and the second side region. In other words, each first bridge element 34 decreases the thermal resistance between the first and second side regions a little bit (compared to a device with no first bridge element in that position). But on the other hand, each first bridge element 34 increases the mechanical integrity of the structure 1 and reduces the risk that the structure 1 would experience irregular resonance where it does not oscillate as a single body. The optimal value for N depends at least on the desired resonance frequency, on the material and dimensions of the structure 1, on the design of the end bridges and on the dimensions of the bridge elements themselves. The optimal value may be determined with computer simulations.

In general, in devices where there are two or more openings, the two or more openings may comprise two or more first openings 36, and the one or more bridge elements may comprise one or more first bridge elements 34, and the two or more first openings 36 and one or more first bridge elements 34 may lie on a first central line 38 which extends from the first end to the second end, so that the one or more first bridge elements 34 separate the two or more first openings 36 from each other.

With reference to figure 3b, in devices where the two or more openings comprise two or more first openings 36 on a first central line 38, the two or more openings may also comprise two or more second openings 37. The one or more bridge elements may also comprise one or more second bridge elements 35. The two or more second openings 37 and one or more second bridge elements 35 may lie on a second central line 39 which extends from the first end 11 to the second end 12, so that the one or more second bridge elements 35 separate the two or more second openings 37 from each other. The first central line 38 may be closer to the first side region 13 than the second central line 39.

The one or more bridge elements may in figure 3b comprise a central bridge element 25 which lies between the first (38) and second (39) central lines, so that the central bridge element 25 separates the two or more first openings 36 from the two or more second openings 37. The one or more first bridge elements 34 extend from the first side region 13 to the central bridge element 25 across the first central line 38. The one or more second bridge elements 35 extend from the second side region 14 to the central bridge element 25 across the second central line 39.

The first openings 36 and second openings 37 may be aligned with each other in the x-direction, as figure 3b illustrates. In other words, each first opening 36 may have the same length as the corresponding second opening 37 which lies on the other side of the central bridge element 25, and the ends of these openings may lie at the same y-coordinates, as figure 3b illustrates. The number N of first bridge elements 34 and the number M of second bridge elements 35 may be equal. Alternatively, N and M may be unequal.

The first central line 38 may be substantially parallel to the second central line 39, and the central bridge element 25 may be substantially parallel to the first central line 38. Other options are also possible. The first (38) and second (39) central lines could for example form a small nonzero angle with each other. Alternatively or additionally, the central bridge element 25 could form a small nonzero angle with one or both of the first (38) and second (39) central lines. The options listed in this paragraph apply to all embodiments in this disclosure where openings are arranged on two central lines.

One or more additional columns with additional openings and bridge elements arranged on additional central lines may be added to the structure 1, and additional central bridge elements which separate these additional central lines from the first (38) or second (39) central line may also be added. This option has not been illustrated.

One of the one or more first bridge elements 34 may lie on a transversal line 31 which is perpendicular to the first central line 38. The word "transversal" refers in this case to a direction which is parallel to the x-axis. In other words, the transversal direction extends from the first side region 13 of the structure 1 toward the second side region 14 of the structure 1. One of the one or more second bridge elements 35 may also lie on the transversal line 31, as figure 3b illustrates. However, this alignment of first (34) and second (35) bridge elements may not always be optimal because it creates a short heat transfer path from the first side region 13 to the second side region 14.

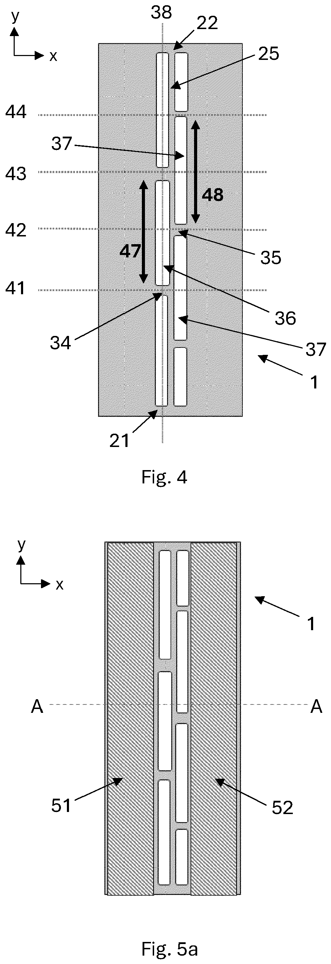

Figure 4 illustrate a structure 1 where one of the one or more first bridge elements 34 lies on a transversal line 41 which is perpendicular to the first central line 38, and none of the one or more second bridge elements 35 lies on the transversal line 41. In other words, the first bridge element 34 is not aligned with any of the second bridge elements 35 in the x-direction. This increases the path distance from the first side region to the second side region, and thereby increases the heat transfer resistance of the central part.

The heat resistance can be increased by arranging the first and second bridge elements so that none of them lie on the same transversal line. In figure 4, for example, the first bridge elements lie on transversal lines 41 and 43, while the second bridge elements lie on the transversal lines 42 and 44 (the transversal line has not been marked for the lowermost second bridge element in the figure).

Many different geometries could be implemented. Figure 4 illustrates a geometry where each second bridge element (35) lies on a transversal line (42, 44) which extends substantially through the middle of the adjacent first opening 36 which lies on the opposite side of the central bridge element 25. In other words, the first opening 36 has a length 47 in the y-direction, and the transversal line 42 cuts this length in half. Conversely, each first bridge element (34) lies on a transversal line (41, 43) which extends substantially through the middle of the adjacent second opening 37 on the opposite side of the central bridge element 25. For example, the transversal line 43 divides the length 48 in two equal halves. This arrangement can in some applications provide greater thermal resistance between the first and second side regions than the arrangement illustrated in figure 3b, because the lengths of the heat transfer paths across the one or more bridge elements are increased.

As explained previously, the mechanical integrity of the structure 1 in bending oscillation must also be taken into account when bridge positions are selected. In figure 3b, the one or more bridge elements (21, 22, 25, 34, 35) form a grid with four-way intersections (i.e. plus-shaped crossing) between the first/second bridge elements 34 and 35 and the central bridge element 25 and with three-way intersections (T-shaped crossing) between the central bridge element 25 and each of the first and second end bridges 21 and 22. The same applies to devices with more than two openings on both the first (38) and second (39) central lines, as long as each first bridge element 34 has the same y-coordinate as the adjacent second bridge element 35.

In figure 4, the one or more bridge elements (21, 22, 25, 34, 35) form a grid with three-way intersections between the first/second bridge elements 34 and 35 and the central bridge element 25 and with three-way intersections between the central bridge element 25 and each of the first and second end bridges 21 and 22. The same applies to devices with more openings on both the first (38) and second (39) central lines, as long as no first bridge element 34 has the same y-coordinate as the adjacent second bridge element 35. The three-way intersections 34+25 and 35+25 may be more flexible in the x-direction than the four-way intersections illustrated in figure 3b.

In any embodiment presented in this disclosure, the one or more bridge elements may have the same thickness as the first side region and as the second side region in a direction which is perpendicular to the plane. In other words, using figure 2d as an example, the thickness of the central bridge element 25 in the z-direction may be equal to the thickness of the side regions 13 and 14 in the z-direction. The two or more openings may be formed by etching through the device layer, in the same process where the structure 1 is formed in the device layer. This will typically lead to equal thickness in the central bridge element 25 and the side regions 13 and 14. However, it is also possible to perform an etching process which recesses the one or more bridge elements from one or both sides of the device layer. Consequently, the thickness of the one or more bridge elements may alternatively be less than the thickness of the structure 1 in the first side region 13 and the second side region 14 (this option has not been illustrated).

The bending oscillation which the structure 1 experiences may be induced by one or more capacitive drive transducers, and/or the oscillation may be measured by capacitive sense transducers. The structure 1 may itself form a part of such a capacitive transducer, and another part of the capacitive transducer may be a counter-electrode located on an adjacent fixed structure. A drive voltage signal applied between the counter-electrode and the structure 1 may generate an electrostatic driving force if the transducer is used as a drive transducer. If the transducer is used as a sense transducer, the variation of the capacitance between the oscillating structure 1 and the fixed counter-electrode may generate a sense voltage signal.

The bending oscillation may alternatively be induced by one or more piezoelectric drive transducers, and/or the oscillation may be measured by piezoelectric sense transducers. In other words, the MEMS device may comprise a piezoelectric drive transducer on the structure, and the piezoelectric drive transducer may be configured to actuate the structure into bending oscillation. Alternatively or additionally, the MEMS device may comprise a piezoelectric sense transducer on the structure, and the piezoelectric sense transducer may be configured to measure the bending oscillation of the structure.

Figure 5a illustrates a first piezoelectric transducer 51 and a second piezoelectric transducer 52 on the top surface of the structure 1 described in figure 4. The first piezoelectric transducer 51 may for example lie on the first side region 13 of the structure 1, and the second piezoelectric transducer may lie on the second side region 14. The transducers may cover substantially the entire side region in the xy-plane, as figure 5a illustrates. Alternatively, they may cover a part of the side region, but not all of it.

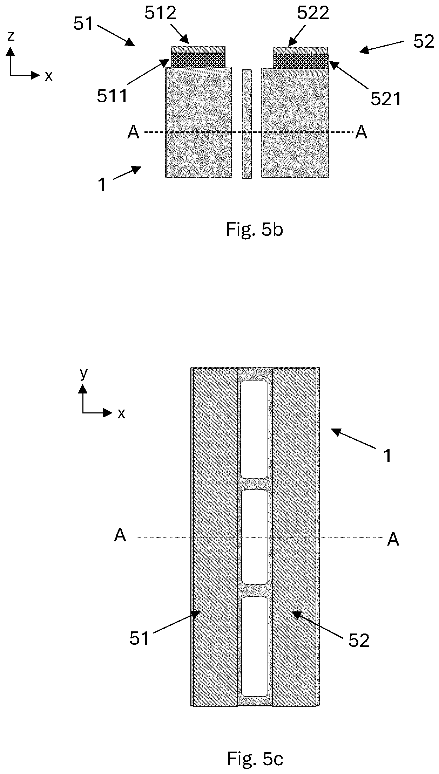

Figure 5b illustrates an xz cross-section of the structure illustrated in figure 5a along the line A - A. The first piezoelectric transducer 51 may comprise a first layer of piezoelectric material 511 on the top surface of the structure 1, and a first electrode 512 on top of the first layer of piezoelectric material 511. The second piezoelectric transducer 52 may comprise a second layer of piezoelectric material 521 on the top surface of the structure 1, and a second electrode 522 on top of the second layer of piezoelectric material 521. The structure 1 may itself be used as the opposite electrode in both piezoelectric transducers. The structure 1 may for example semiconductive, and it may be set to a first electric potential.

A voltage may be applied across the piezoelectric materials 511 and 521 by setting the first and second electrodes 512 and 522 to electric potentials which differ from first electric potential which is applied to the structure 1. The first and second piezoelectric transducers 51 and 52 may be configured to generate a bending force on the structure 1 when drive voltage signals are applied to the respective first and second electrodes 512 and 522. The transducers 51 and 52 are in this case used as drive transducers which actuate the bending oscillation.

Alternatively, the bending which the structure 1 experiences at any given moment may be measured by measuring the electric potential of the first and second electrodes 512 and 522. The transducers 51 and 52 are in this case used as sense transducers. The bending of the transducer, and of the piezoelectric layer(s), may in this case generate a current which may be converted into a sense voltage signal in a charge amplifier.

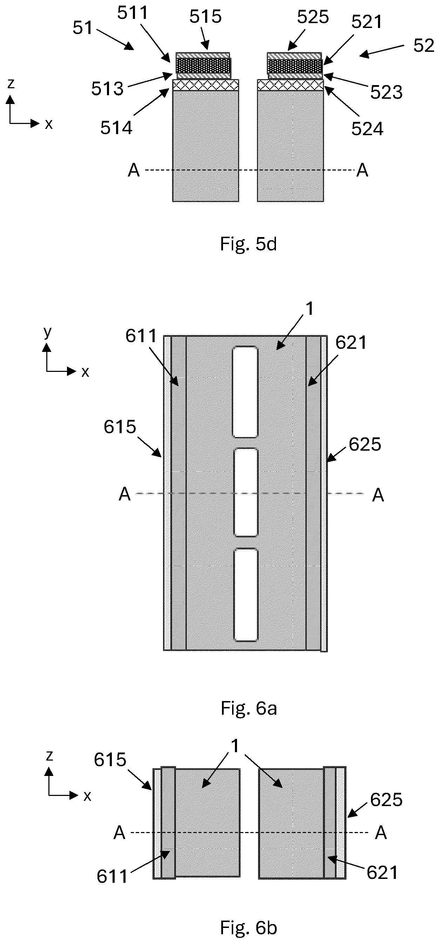

Figure 5c illustrates first and second piezoelectric transducers 51 and 52 on a structure 1 which corresponds to figure 3a above. Figure 5d illustrates the xz cross-section along the line A - A in figure 5c. Here the MEMS device comprises insulating layers 514 and 524 on the top surface of the structure 1 in the first and second side regions, and the transducers 51 and 52 are built on top of these insulating layers. The insulating layers may for example be made of silicon dioxide. Each transducer 51 and 52 comprises a bottom electrode 513 / 523 and a top electrode 515 / 525. The layer of piezoelectric material 511 / 521 is sandwiched between the bottom electrode 513 / 523 and the top electrode 515 / 525. The first and second piezoelectric transducers 51 and 52 can be used as drive transducers by setting a voltage between the bottom electrode 513 / 523 and the top electrode 515 / 525, and as sense transducers by measuring the voltage between the bottom electrode 513 / 523 and top electrode 515 / 525.

It is also possible, in any figure 5a - 5d, to use the first piezoelectric transducer 51 as a drive transducer and the second piezoelectric transducer 52 as a sense transducer. Figures 5a - 5d illustrate piezoelectric transducers on the structures 1 that were previously introduced in figures 3a and 4. However, piezoelectric transducers can be implemented in the same way in any embodiment described in this disclosure. It would also be possible, in any embodiment presented in this disclosure, to build a piezoelectric transducer on the top surface of the structure 1 in the first side region 13, but not in the second side region 14. This option has not been separately illustrated.

Figures 6a - 6b illustrate an alternative transducer configuration. Figure 6a shows a first piezoelectric transducer 61 and a second piezoelectric transducer 62 on the two opposing side surfaces of the structure 1. In other words, the transducer structures have in this case been deposited on the two side surfaces which are parallel to the yz-plane, on the left and right sides of the structure 1. The transducers may cover substantially the entire side surface, as figures 6a - 6b illustrate. Alternatively, they may cover a part of the side surface, but not all of it.

Figure 6b illustrates an xz cross-section of the structure illustrated in figure 6a along the line A - A. The first piezoelectric transducer 61 may comprise a first layer of piezoelectric material 611 on the left side surface of the structure 1, and a first electrode 615 on top of the first layer of piezoelectric material 611. The second piezoelectric transducer 62 may comprise a second layer of piezoelectric material 621 on the right-side surface of the structure 1, and a second electrode 625 on top of the second layer of piezoelectric material 621. The structure 1 may itself be used as the opposite electrode in both piezoelectric transducers. As in the previous examples, the structure 1 may for example semiconductive.

The other options presented above with reference to figures 5a - 5b apply also to the transducers in figures 6a - 6b. The transducers may for example include additional electrodes and insulating layers, and they can be used as drive transducers or as sense transducers.

In any embodiment presented in this disclosure, the first end of the structure may be attached to a fixed anchor point.

## Claims

1. A MEMS device which comprises a structure which is configured to undergo bending oscillation in a plane, wherein the structure comprises:
- a first end and a second end,
- a first side region which extends from the first end to the second end,
- a second side region which extends from the first end to the second end,
- a central region which extends from the first end to the second end between the first side region and the second side region,
wherein the first side region lies on a first side of the central region, and the second side region lies on a second side of the central region, and the first side of the central region is opposite to the second side of the central region,
**characterized in that** in the central region comprises one or more openings which extend through the structure.

2. A MEMS device according to claim 1, wherein the one or more openings comprise two or more openings, and the central region comprises one or more bridge elements which separate the two or more openings from each other.

3. A MEMS device according to claim 2, wherein the two or more openings comprise two or more first openings, and the one or more bridge elements comprise one or more first bridge elements, and the two or more first openings and one or more first bridge elements lie on a first central line which extends from the first end to the second end, so that the one or more first bridge elements separate the two or more first openings from each other.

4. A MEMS device according to claim 3, wherein the two or more openings also comprise two or more second openings, and the one or more bridge elements also comprise one or more second bridge elements, and the two or more second openings and one or more second bridge elements lie on a second central line which extends from the first end to the second end, so that the one or more second bridge elements separate the two or more second openings from each other, wherein the first central line is closer to the first side region than the second central line, and
the one or more bridge elements comprises a central bridge element which lies between the first and second central lines, so that the central bridge element separates the two or more first openings from the two or more second openings, and the one or more first bridge elements extend from the first side region to the central bridge element across the first central line, and the one or more second bridge elements extend from the second side region to the central bridge element across the second central line.

5. A MEMS device according to claim 4, wherein the first central line is substantially parallel to the second central line, and the central bridge element is substantially parallel to the first central line.

6. A MEMS device according to any of claims 4-5, wherein one of the one or more first bridge elements lies on a transversal line which is perpendicular to the first central line, and none of the one or more second bridge elements lies on the transversal line.

7. A MEMS device according to any of claims 2-6, wherein the one or more bridge elements have the same thickness as the first side region and as the second side region in a direction which is perpendicular to the plane.

8. A MEMS device according to any preceding claim, wherein the MEMS device comprises a piezoelectric drive transducer on the structure, and the piezoelectric drive transducer may be configured to actuate the structure into bending oscillation.

9. A MEMS device according to any preceding claim, wherein the MEMS device comprises a piezoelectric sense transducer on the structure, and the piezoelectric sense transducer is configured to measure the bending oscillation of the structure.

10. A MEMS device according to any preceding claim, wherein the first end of the structure is attached to a fixed anchor point.

11. A MEMS device according to any preceding claim, wherein the structure is made of silicon.

12. A MEMS device according to any preceding claim, wherein the one or more openings extend through the structure in a direction which is perpendicular to the plane.

13. A MEMS device according to any preceding claim, wherein the MEMS device is a timing device or a frequency reference device.

14. A MEMS device according to any of claims 1 - 12, wherein the MEMS device is a gyroscope.

15. A MEMS device according to any of claims 1 - 12, wherein the MEMS device is a mirror device.
